# EUROPEAN PATENT APPLICATION

(11) **EP 4 779 660 A1**
(43) Date of publication of application: **22.07.2026**
(21) Application number: 26151217.2
(22) Date of filing: 12.01.2026
(51) Int. Cl.: H01F 17/06, H01F 27/06, H02M 3/00, H02M 7/00, H05K 1/181, H05K 1/02, H05K 1/14, H01F 27/29

(54) **INDUCTOR ARRAY DESIGN FOR HIGH DENSITY VERTICAL POWER DELIVERY APPLICATION**

(30) Priority: 16.01.2025 US 202519025705
(71) Applicant: Tesla, Inc., Austin, TX 78725 (US)
(72) Inventor: ZHAO, Jin, Austin, TX 78725 (US); IYER, Kartik, Austin, TX 78725 (US)
(74) Representative: Liesegang, Eva

(57) **Abstract**

An inductor cell for vertical power delivery includes a first plate, a second plate, a power conductor, an inductor core, and a ground conductor. The power conductor extends between the first plate and the second plate in a vertical direction. The inductor core extends between the first plate and the second plate in the vertical direction. The ground conductor extends between the first plate and the second plate in the vertical direction. The power conductor is configured to deliver power between the first plate and the second plate along the vertical direction. The inductor cell is configured as an inductor in a power delivery path.

## Description

### TECHNICAL FIELD

The present disclosure relates to inductor arrays and related inductor cells. More particularly, some embodiments of the present disclosure relate to inductor arrays for vertical power delivery in high-density computing applications.

### BACKGROUND

Computing systems include a plurality of chips and associated electronics, such as power supply modules. High computing density is desirable. To achieve high computing density, there is limited area for the associated electronics. The capability and efficiency of power delivery typically has a significant impact on system performance.

### SUMMARY OF CERTAIN INVENTIVE ASPECTS

The systems, methods and devices of this disclosure each have several innovative embodiments, no single one of which is solely responsible for all of the desirable attributes disclosed herein. Details of one or more implementations of the subject matter described in this specification are set forth in the accompanying drawings and the description below.

In some aspects, the techniques described herein relate to an inductor cell, including: a first plate; a second plate; a power conductor extending between the first plate and the second plate in a vertical direction; an inductor core extending between the first plate and the second plate in the vertical direction; and a ground conductor extending between the first plate and the second plate in the vertical direction, wherein the power conductor is configured to deliver power between the first plate and the second plate along the vertical direction, and wherein the inductor cell is configured as an inductor in a power delivery path.

In some aspects, the techniques described herein relate to an inductor cell, wherein the first plate includes a power plane and a ground plane, wherein the power plane is electrically connected to the power conductor, and wherein the ground plane is electrically connected to the ground conductor.

In some aspects, the techniques described herein relate to an inductor cell, wherein the power plane is disposed above, below, or overlapped with the ground plane.

In some aspects, the techniques described herein relate to an inductor cell, wherein the ground conductor includes a plurality of soldering points for mounting the ground plane on the ground conductor.

In some aspects, the techniques described herein relate to an inductor cell, further including a plurality of vias configured to electrically connect between power planes, or ground planes respectively.

In some aspects, the techniques described herein relate to an inductor cell, wherein the first plate includes a first printed circuit board (PCB), and wherein the second plate includes a second PCB.

In some aspects, the techniques described herein relate to an inductor cell, wherein the inductor core at least partially surrounds the power conductor, and wherein the ground conductor at least partially surrounds the inductor core.

In some aspects, the techniques described herein relate to an inductor cell, wherein the inductor core is contiguous, and wherein the power conductor includes two power conductor pieces and the ground conductor includes two ground conductor pieces to deliver the power under a dual-phase operation.

In some aspects, the techniques described herein relate to an inductor cell, wherein the inductor core is contiguous, and wherein the power conductor includes multiple power conductor pieces and the ground conductor includes multiple ground conductor pieces to deliver the power under a multi-phase operation.

In some aspects, the techniques described herein relate to an inductor array, including: a plurality of inductor cells arranged in an array, wherein each of the plurality of inductor cells includes: a power conductor; an inductor core; a ground conductor; a first plate; and a second plate, wherein the power conductor, the inductor core, and the ground conductor are disposed between the first plate and the second plate, and wherein electrical power is delivered between the first plate and the second plate along a vertical direction through the power conductor; and the ground conductor provides a return current path.

In some aspects, the techniques described herein relate to an inductor array, wherein the power conductor is contiguous and the ground conductor is contiguous, and the inductor cell is configured to deliver the electrical power under a single-phase operation.

In some aspects, the techniques described herein relate to an inductor array, wherein the power conductor includes two power conductor pieces and the ground conductor includes two ground conductor pieces to deliver the electrical power under a dual-phase operation.

In some aspects, the techniques described herein relate to an inductor array, wherein the power conductor includes four power conductor pieces and the ground conductor includes four ground conductor pieces to deliver the electrical power under a quad-phase operation.

In some aspects, the techniques described herein relate to an inductor array, wherein the inductor core at least partially surrounds the power conductor, and wherein the ground conductor at least partially surrounds the inductor core.

In some aspects, the techniques described herein relate to an inductor array, wherein the power conductor is substantially cylindrical.

In some aspects, the techniques described herein relate to an inductor array, wherein the ground conductor includes one or more ground legs configured to facilitate soldering between the ground conductor and the first plate.

In some aspects, the techniques described herein relate to a computing system, including: an array of chips including a plurality of chips; and an array of power delivery modules including a plurality of power delivery modules, wherein each power delivery module of the plurality of power delivery modules is positioned vertically relative to and configured to vertically supply power to a respective chip of the plurality of chips, and wherein each power delivery module of the plurality of power delivery modules includes an inductor cell, and the inductor cell includes: a power conductor; a ground conductor around the power conductor; a first printed circuit board; a second printed circuit board, wherein the power conductor and the ground conductor are positioned between the first printed circuit board and the second printed circuit board, and are arranged to deliver power between the first printed circuit board and the second printed circuit board.

In some aspects, the techniques described herein relate to a computing system, wherein a system on a wafer includes the array of chips.

In some aspects, the techniques described herein relate to a computing system, wherein each power delivery module of the plurality of power delivery modules includes a buck converter, and the inductor cell is an output inductor of the buck converter.

In some aspects, the techniques described herein relate to a computing system, wherein each power delivery module of the plurality of power delivery modules includes: a capacitor; and a driver plus metal oxide semiconductor field effect transistor layer, wherein the inductor cell is positioned vertically between the capacitor and the driver plus metal oxide semiconductor field effect transistor layer.

### BRIEF DESCRIPTION OF THE DRAWINGS

Throughout the drawings, reference numbers are re-used to indicate correspondence between referenced elements. The drawings are provided to illustrate examples of the subject matter described herein and not to limit the scope thereof.

Embodiments of the present disclosure are described with reference to the accompanying drawings, in which like reference characters reference like elements, and wherein:
Figure 1 is a schematic diagram of a system on a wafer assembly that includes an array of chips and an array of power supply modules arranged to provide power supply vertically to the chips in accordance with some embodiments of the present disclosure.
Figure 2 is a schematic diagram of an array of power supply modules in accordance with some embodiments of the present disclosure.
Figure 3 is a schematic diagram of an array of power supply modules arranged to provide power vertically to an array of chips in accordance with some embodiments of the present disclosure.
Figure 4 illustrates a perspective view of an example inductor cell for vertical power delivery in accordance with some embodiments of the present disclosure.
Figures 5A, 5B, 5C, 5D, and 5E illustrate the example inductor cell of Figure 4 at various stages of an example assembly process accordance with some embodiments of the present disclosure.
Figures 6A and 6B illustrate dual-phase vertical power delivery using the example inductor cell of Figure 4 in accordance with some embodiments of the present disclosure.
Figure 7A illustrates physical characteristics associated with an example inductor cell that can be the same or similar to the example inductor cell of Figure 4 for vertical power delivery in accordance with some embodiments of the present disclosure.
Figure 7B illustrates an inductor array formed by the example inductor cell of Figure 7A in accordance with some embodiments of the present disclosure.
Figure 8 is an example block diagram of components of a power supply module for vertical power delivery in accordance with some embodiments of the present disclosure.

### DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals and/or terms can indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings. The headings are provided for convenience only and do not impact the scope or meaning of the claims.

Generally described, one or more aspects of the present disclosure relate to systems and methods that utilize array-based inductor design for facilitating vertical power delivery. More specifically, some embodiments of the present disclosure relate to vertical power delivery using inductor cells, where each of the inductor cells provides a vertical connection for power delivery. Compared with delivering power in a horizontal direction, the vertical connection for power delivery can achieve more efficient power transfer from one layer (e.g., a printed circuit board (PCB) on top) of a vertical power delivery system (e.g., a power supply module, a buck converter, a voltage regulator module, or the like) to another layer (e.g., a PCB at bottom) of the vertical power delivery system. The vertical power delivery system can also be more suitable to support high-density computing applications that involve supplying a relatively large amount of power under or within confined physical spaces, which can be unattainable using horizontal power delivery.

In some embodiments, a plurality of inductors can be integrated into one or more inductor arrays that can be integrated into a vertical power delivery system. An inductor array can be assembled or manufactured as a single component, which may simplify the integration process of the vertical power delivery system. The inductor array can generally include *N* x *M* inductors (e.g., *N* inductor cells in a first dimension and *M* inductor cells in a second dimension, where the second dimension is orthogonal to the first dimension). The number of inductors within the inductor array can be flexibly adjusted based on specific applications that the vertical power delivery system supports.

In some embodiments, the inductor array can include multiple inductors spatially arranged in a stacked layer structure. The inductor array can be configured for multi-phase (e.g., dual-phase, quad-phase, or the like) operations. Each phase of the inductor array may correspond to a phase of a buck converter. By configuring the inductor array to dual-phase, or quad-phase based on applications, the vertical power delivery system can advantageously allow more efficient multi-phase power conversion and delivery in a vertical direction.

Additionally, and/or optionally, parameters associated with an inductor array of the vertical power delivery system can be customized for specific applications. For example, various inductor parameters such as resistance, inductance, saturation current, and/or size can be adjusted based on switching frequency, output current, and/or efficiency targets of a direct current to direct current (DC-DC) buck converter.

A power delivery system typically includes components such as inductors, capacitors, transformers, or semiconductor devices to convert, control, and condition electric power. For example, a power delivery system may use the components to deliver power to various loads or convert power from one form to another (e.g., alternating current (AC) to DC, DC to AC, or DC to DC). Traditionally, a power delivery system uses horizontal power delivery, where components such as inductors are surface-mounted on a printed circuit board (PCB).

As technology advances, applications such as data centers, artificial intelligence (AI) training, or machine learning systems are becoming more prevalent. For these applications, high-density and efficient power delivery may be desired and/or significant because these applications usually involve support from a power delivery system that can handle high power density and provide efficient data exchange through high bandwidth interconnections. However, horizontal power delivery systems may fail to meet stringent power demands from these applications due to resistance, inductance, and/or limited scalability of such horizontal power delivery.

To address at least a portion of the above identified technical problems, some aspects of the disclosed technology relate to a vertical power delivery system that uses an array-based inductor design to provide specified power density and efficiency for high-density computing applications. The vertical power delivery system can provide vertical power delivery using one or more inductor cells, where each of the one or more inductor cells provides a vertical connection for power delivery. In some embodiments, an inductor cell of the vertical power delivery system may employ several components to form power efficient and compact inductor arrays(s) that can be integrated into the vertical power delivery system (e.g., a power supply module, a buck converter, a voltage regulator module, or the like).

For example, the inductor cell may include at least an inductor core, a power conductor, and a ground conductor. In some embodiments, the inductor core can be a powder core. The powder core can be made from finely powdered magnetic materials that are bound together to provide adequate magnetic permeability, relatively low core loss, distributed air gaps, and/or thermal stability. The power conductor can carry electrical current from a power source to the inductor. The power conductor can handle specified current levels with desired resistance and power loss. The ground conductor can provide a voltage reference for the inductor cell and provide a return path for electrical current. The power conductor can be at least partially surrounded by the powder core, and the powder core can be at least partially surrounded by the ground conductor. The power conductor and the ground conductor can be oriented vertically to facilitate vertical power transfer.

The inductor cell may further include a ground plane and a power plane. The ground plane may include an area of conductive material (e.g., copper) that serves as a common reference point for the inductor cell and/or electrical circuits associated with the inductor cell. The ground plane may be electrically connected to the ground conductor to provide a low-impedance path for a return current and to help in reducing electromagnetic interference (EMI) and noise. The power plane may include an area of conductive material, and may be electrically connected to the power conductor to provide a low-impedance path for supplying current and contributing to reducing voltage drops and power losses.

In some embodiments, the power conductor, the inductor core (e.g., the powder core), and the ground conductor of the inductor cell may be mounted and/or sandwiched between two PCBs. The two PCBs may include insulating materials such as fiberglass or epoxy resin and conductive traces etched onto surfaces and/or layers of the two PCBs. The two PCBs may provide mechanical support and electrical interconnections for the power conductor, the powder core, and the ground conductor. The ground plane may be implemented in one layer of a PCB, and the power plane may be implemented in another layer of the PCB.

Additionally, and/or optionally, the inductor cell may include a plurality of vias. The plurality of vias may provide vertical interconnections that connect the power plane and the ground plane, and/or connect layers of the PCBs. The vias can facilitate flow of current between the power conductor and the ground conductor, thereby enabling efficient vertical power delivery between PCBs. Additionally, and/or optionally, the inductor cell may include one or more soldering points (e.g., ground legs) that can be utilized to securely attach various components (e.g., attaching the ground conductor to the ground plane) with each other. Advantageously, the one or more soldering points may help to provide reliable electrical connections between components of the inductor cell and help maintain structural integrity of the vertical power delivery system.

In some embodiments, a plurality of inductors may be integrated with each other to form an inductor array. The inductor array can be soldered between multiple PCBs that are stacked together for supporting various applications. For example, the inductor array may be included in a DC-DC buck converter. As noted above, the inductor array can generally include *N* x *M* inductors (e.g., *N* inductor cells in a first dimension and *M* inductor cells in a second dimension, where *N* and *M* are positive integers). The number of inductors within the inductor array can be flexibly adjusted based on specific applications that the vertical power delivery system supports. For some applications, the inductor array may include 6 x 6 inductors, 3 x 3 inductors, or the like.

In some embodiments, the inductor array can include multiple inductors spatially arranged in a stacked layer structure. At least some parts of the inductor array can be configured for multi-phase (e.g., single-phase, dual-phase, quad-phase, or the like) operations based on supported applications. When configured to operate under a single-phase configuration, an inductor cell may deliver power in a single phase. Under the single-phase configuration, a power conductor of the inductor cell may comprise a single conductor rather than multiple conductor pieces. The ground conductor of the inductor cell may comprise a single conductor rather than multiple conductor pieces. Compared with dual-phase or quad-phase, the single-phase configuration may be easier to implement. On the other hand, dual-phase or quad-phase inductor cell configuration may achieve higher power density and/or power efficiency.

Under the dual-phase configuration, the inductor cell may deliver power in two distinct phases (e.g., 0 degrees and 180 degrees). Under the dual-phase configuration, a power conductor of the inductor cell may comprise two conductor pieces. The ground conductor of the inductor cell may comprise two conductor pieces. Compared with the single-phase configuration, the dual-phase configuration of the inductor cell may achieve improved power delivery efficiency and better load regulation.

Under the quad-phase configuration, the inductor cell may deliver power in four distinct phases (e.g., 45 degrees, 135 degrees, 225 degrees, and 315 degrees). Under the quad-phase configuration, a power conductor of the inductor cell may comprise four conductor pieces. The ground conductor of the inductor cell may comprise four conductor pieces. A quad-phase inductor array may be implemented for applications with demanding power specifications, such as high-performance computing and advanced AI training systems. By distributing the power load across four distinct phases, the inductor cell may reduce and/or minimize voltage ripple, improve transient response, and enhance the overall performance of the power delivery system. In some applications, each phase of an inductor array may correspond to a phase of a buck converter. By configuring the inductor array to single-phase, dual-phase, or quad-phase inductor cells based on applications, the vertical power delivery system can advantageously allow more efficient multi-phase power conversion and delivery in a vertical direction.

Additionally, and/or optionally, parameters associated with an inductor array of the vertical power delivery system can be customized for specific applications. For example, various inductor parameters such as resistance, inductance, saturation current, and/or size (e.g., thickness, length, diameter, width of a power conductor, a ground conductor, and/or a powder core of an inductor cell) can be selected based on switching frequency, output current, and/or efficiency targets of a direct current to direct current (DC-DC) buck converter to meet power demands of high-density computing applications such as AI training and machine learning.

In some embodiments, the resistance of an inductor cell can be customized by selecting appropriate materials for the power conductor and optimizing its cross-sectional area. For example, using materials with high electrical conductivity, such as copper, and increasing the thickness of the conductor can reduce resistance. In some embodiments, the inductance of an inductor cell can be adjusted by modifying the core material and/or the geometry of the inductor cell. For example, using a powder core with high magnetic permeability can increase inductance. In some embodiments, the saturation current associated with an inductor cell can be customized such that the inductor cell can handle the peak current demands of the application without performance degradation. Customization of the saturation current can be achieved by selecting materials (e.g., materials used for a powder core or another suitable inductor core) with high saturation flux density and adjusting the core geometry to distribute the magnetic flux evenly. Additionally, increasing the cross-sectional area of the powder core or the inductor core, the power conductor, and/or the ground conductor can help manage higher currents. In some embodiments, the size of an inductor cell can be selected based on one or more of the buck converter's switching frequency, output current, or efficiency targets. For example, a compact design based on vertical orientations associated with the power conductor and the ground conductor may be utilized for applications with limited space, while larger inductor cell size may be used in applications or systems where space is less constrained.

As used herein, vertical power delivery can refer to delivering power from a first circuit (e.g., a power supply module) to a second circuit (e.g., an integrated circuit (IC), an array of ICs, an array of chips, a system on chip (SOC), or the like) that is disposed on a substrate in a direction perpendicular to or otherwise not parallel to a plane defined by the substrate (e.g., a printed circuit board (PCB), a semiconductor piece, an organic substrate, an inorganic substrate, or the like). For example, power can be delivered vertically from the power supply module to the array of chips that are disposed on the PCB in a direction that is perpendicular to a plane defined by the PCB. The PCB can be mounted (e.g., using mounting holes with standoffs to elevate and secure the PCB above a chassis surface of a compute server) to the compute server.

Although aspects of the present disclosure will be described with reference to illustrative components, interactions, and routines, one skilled in the relevant art will appreciate that one or more aspects of the present disclosure may be implemented in accordance with various environments, system architectures, customer computing device architectures, and the like. Similarly, references to specific devices, such as an inductor cell or an inductor array, can be considered general references and not intended to provide additional meaning or configurations for the individual inductor cell or inductor array. Still, further, illustrations and example configurations are not intended to be limited and should not be construed as limiting the scope of the present disclosure. Additionally, the examples are intended to be illustrative in nature and should not be construed as limiting.

### Example Vertical Power Delivery System

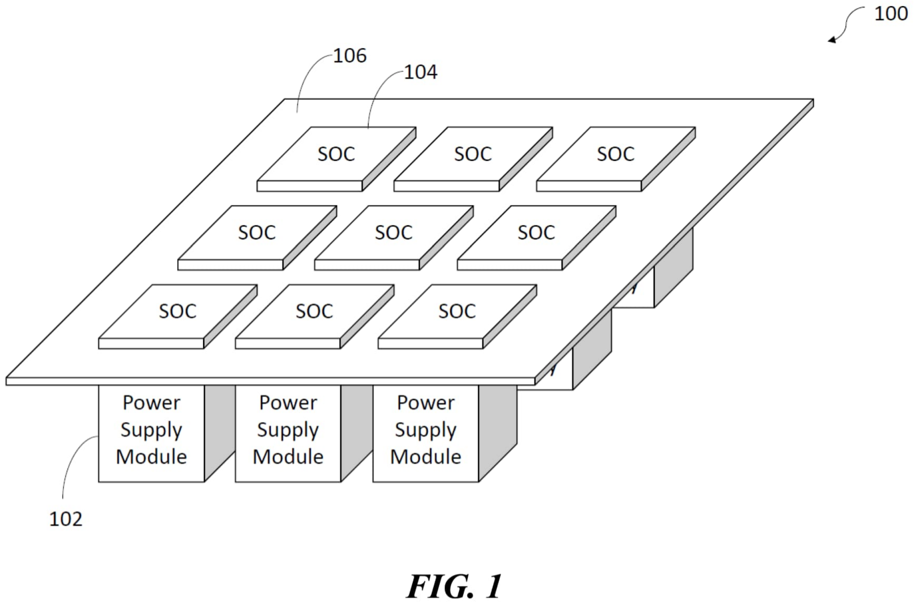

Figure 1 is a schematic diagram of a system on wafer (SOW) assembly 100 that includes an array of power supply modules 102 and an array of chips 104 arranged to receive power supply signals vertically from the power supply module 102. A SOW can include the array of chips 104 and the substrate 106. The substrate 106 can include a plurality of routing layers. A SOW assembly includes one or more wafer level packaging structures around the SOW. The SOW assembly 100 can be included in a processing system with a high compute density. Such a processing system can be used in and/or specifically configured for high performance computing and/or computation intensive applications, such as neural network training and/or processing, machine learning, artificial intelligence, or the like. The processing system can generate data for an autopilot system for a vehicle.

As illustrated in Figure 1, an array of chips 104 are on a substrate 106. The array can include a plurality of chips 104 that are each an instance of a computing chip for a distributed computing application. Each chip 104 of the array can be an integrated circuit die. Each chip 104 of the array can be an SOC. The chips 104 can interface with each other (e.g., through one or more input/output blocks of a chip 104) to implement distributed computing functionality. For example, each chip 104 can be electrically connected with each neighboring chip 104 that is directly adjacent in a row or column of the array. The chips 104 can be located in close proximity to each other to facilitate short routes between chips and to implement high compute density. Each chip 104 can execute computing operations that include one or more of computation, storage, and communication external to the chip.

The array of power supply modules 102 includes a plurality of power supply modules 102 arranged to vertically deliver power to a respective chip 104. Each power supply module 102 can implement a power conversion path with a plurality of power conversion stages. Vertical power delivery can improve performance relative to lateral power delivery by reducing direct current losses. There can be less resistive losses with a shorter path between a power supply module 102 and a chip 104 that are positioned vertically relative to each other. To achieve a high compute density and vertical power delivery, a power supply module 102 can have the same or a similar footprint as a chip 104. With such a design, the array of power supply modules 102 should not cause any additional spacing between chips 104. As shown in Figure 1, each power supply module 102 can be aligned with and positioned vertically relative to a respective chip 104.

Each power supply module 102 can be a packaged component that includes a power conversion path, where the power conversion path includes multiple power conversion stages. Alternatively, power conversion paths for a plurality of chips 104 can be implemented as arrays of power conversion circuitry on a plurality of stacked PCBs. Each power supply module 102 can include an inductor cell in accordance with any suitable principles and advantages disclosed herein. The array of power supply modules 102 can include an inductor array in accordance with any suitable principles and advantages disclosed herein.

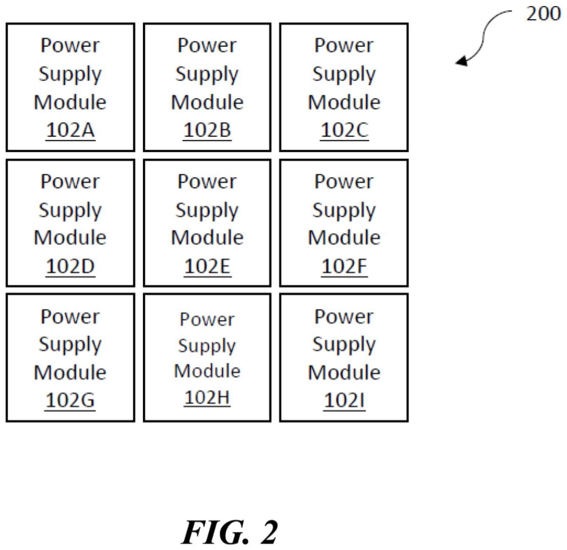

Figure 2 illustrates an array 200 of power supply modules 102A, 102B, 102C, 102D, 102E, 102F, 102G, 102H, and 102I. These power supply modules 102A to 102I can provide power supply signals vertically to chips via electrical connections extending vertically between the power supply modules 102A to 102I and respective chips. The power supply modules 102A to 102I can be located under or above the respective chips. The vertically provided power supply signals are provided orthogonally relative to a major surface of the chip.

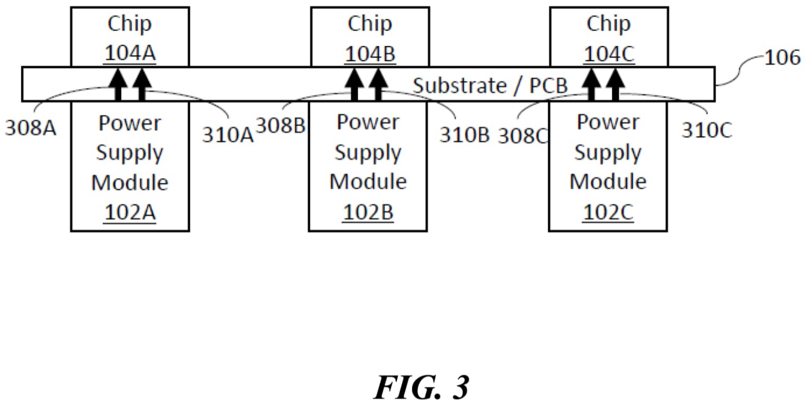

Figure 3 is a schematic diagram of an array of power supply modules 102A to 102C arranged to provide power vertically to an array of chips 104A to 104C according to an embodiment. As shown in Figure 3, chips 104A, 104B, and 104C are positioned on a substrate or printed circuit board 106. On the opposite side of the substrate or printed circuit board 106, there are power supply modules 102A, 102B, and 102C associated with each of the chips. The power supply modules 102A to 102C can include inductor cells in accordance with any suitable principles and advantages disclosed herein. The power supply modules 102A, 102B, and 102C can be power supply modules of the array 200 of Figure 2, for example.

The power supply modules 102A to 102C can vertically deliver power supply signals to the chips 104A to 104C. For example, as shown in Figure 3, power signals can be carried vertically from the power supply modules 102A to 102C to the chips 104A to 104C by way of vertical electrical connections 308A, 308B, 308C, 310A, 310B, and 310C. These electrical connections extend vertically from the power supply modules 102A to 102C to the chips 104A to 104C. The electrical connections can be implemented by pogo pins and/or other suitable vertical connectors.

In some embodiments, the chips 104A to 104C may be disposed on a printed circuit board (for example, singulated from a wafer and then mounted to a circuit board). In certain embodiments, the chips 104A to 104C may be part of a SOW assembly. The SOW assembly can include wafer level packaging. In some such embodiments, a system on a wafer that includes the chips 104 can be an integrated fan-out (InFO) wafer.

In addition to simplifying design by reducing the complex routing to route signals within the plane, vertical power delivery can achieve one or more other advantages. By vertically delivering power, the power losses that typically occur as signals travel laterally on a PCB may be significantly reduced due to shorter delivery paths and corresponding reduced resistance of the delivery paths. Such a reduction may not only reduce the direct current (DC) IR loss (e.g., the decrease in available voltage at the load device, such as a chip), but may also reduce the parasitic loop inductance associated with a current loop, thereby reducing the capacitance for circuit decoupling. Such vertically arranged block arrays may enable high computing density and high-speed communication among the dies of the array, which can be advantageous for AI machine learning applications and other applications where large compute power and high-speed communication are significant advantages.

Example power supply modules 102 are voltage regulating modules. A VRM can convert a direct current voltage to a lower voltage at a higher current to provide a power supply voltage for a chip. VRMs can receive a high voltage, low current input signal and generate a high current, low voltage output signal. VRMs can include a plurality of power conversion stages in accordance with any suitable principles and advantages disclosed herein. The high current, low voltage output can have a current on the order of 100s of Amperes and a voltage of under 1 Volt in certain applications.

In some embodiments, each of the power supply modules 102 of Figure 1, the power supply modules 102A-102I of Figure 2, and the power supply module 102A-102C of Figure 3 can include one or more inductor cells (e.g., an inductor array) that will be described below. The inductor array can facilitate vertical power delivery from power supply modules to circuits to advantageously support AI machine learning applications and other applications where large compute power and high-speed communication are significant advantages.

### Inductor Cells for Vertical Power Delivery

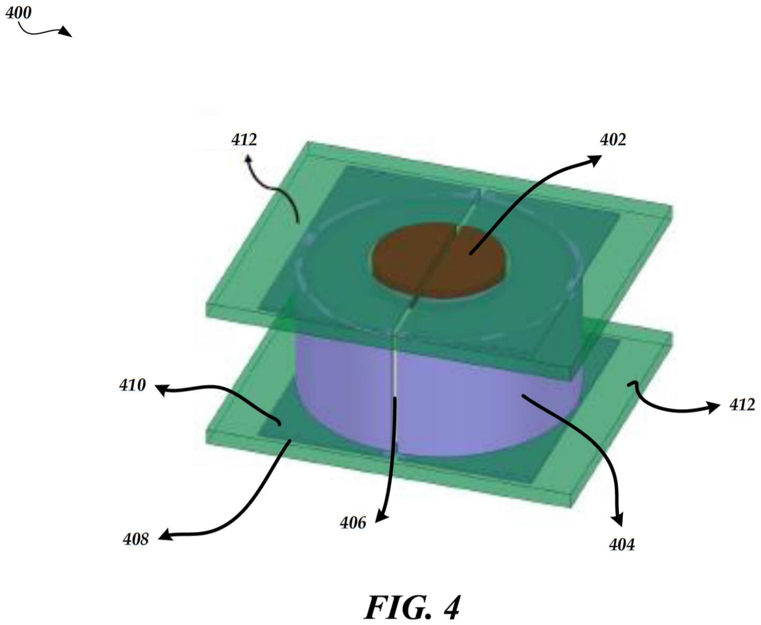

Figure 4 illustrates a perspective view of an example inductor cell 400 for vertical power delivery in accordance with some embodiments of the present disclosure. As noted above, the inductor cell 400 can be deployed in the power supply modules of Figures 1-3 to deliver power vertically. As shown in Figure 4, the inductor cell 400 includes a power conductor 402, a ground conductor 404, a powder core 406, a power plane 408, a ground plane 410, and two printed circuit boards (PCBs) 412. One of the PCBs 412 can be a top plate for the inductor cell 400. The top plate can be disposed above the power conductor 402, the powder core 406, and the ground conductor 404. The other of the PCBs 412 can be a bottom plate for the inductor cell 400. The bottom plate can be disposed below the power conductor 402, the powder core 406, and the ground conductor 404

In some embodiments, the powder core 406 can be made from finely powdered magnetic materials that are bound together to provide adequate magnetic permeability, relatively low core loss, distributed air gaps, and/or thermal stability. The powder core 406 can surround the power conductor 402. In some embodiments, the powder core 406 can be replaced by another suitable inductor core.

The power conductor 402 can carry electrical current from a power source through the inductor cell 400. The power conductor 402 can be handle specified current levels with desired resistance and power loss. As shown in Figure 4, the power conductor 402 is oriented in a vertical direction and can carry electrical current from a power source (not shown in Figure 4) through the inductor cell 400.

The ground conductor 404 can provide a voltage reference for the inductor cell 400 and provide a return path for electrical current. The ground conductor 404 can be oriented vertically to facilitate vertical power delivery. As shown in Figure 4, the power conductor 402 can be at least partially surrounded by the powder core 406. The powder core 406 can be at least partially surrounded by the ground conductor 404.

In some embodiments, the ground plane 410 may include an area of conductive material (e.g., copper and/or another metal or alloy) that serves as a common reference point for the inductor cell 400 or electrical circuits associated with the inductor cell 400. The ground plane 410 may be electrically connected to the ground conductor 404 to provide a low-impedance path for a return current and/or to help in reducing electromagnetic interference (EMI) and noise.

The power plane 408 may include an area of conductive material, and may be electrically connected to the power conductor 402 to provide a low-impedance path for supply current and help in reducing voltage drops and power losses. In some embodiments, the power plane 408 can be above, below, or overlapped with the ground plane 410.

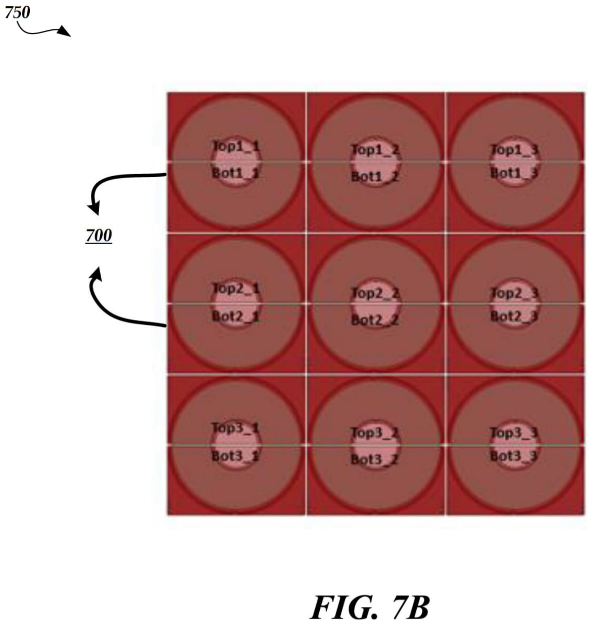

As shown in Figure 4, the power conductor 402, the powder core 406, and the ground conductor 404 of the inductor cell 400 may be mounted and/or sandwiched between two PCBs 412 (e.g., a top plate and a bottom plate). The two PCBs 412 may include insulating materials such as fiberglass or epoxy resin and conductive traces etched onto surfaces and/or layers of the two PCBs 412. The two PCBs 412 may provide mechanical support and electrical interconnections for the power conductor 402, the powder core 406, and the ground conductor 404. In some embodiments, the ground plane 410 may be implemented in one layer of a PCB 412. The power plane 408 may be implemented in another layer of the PCB 412. The PCBs 412 may advantageously facilitate the integration of the inductor cell 400 into an inductor array (e.g., the inductor array of Figure 7B) for implementing a vertical power delivery system.

### Example Process for Assembling Inductor Cells

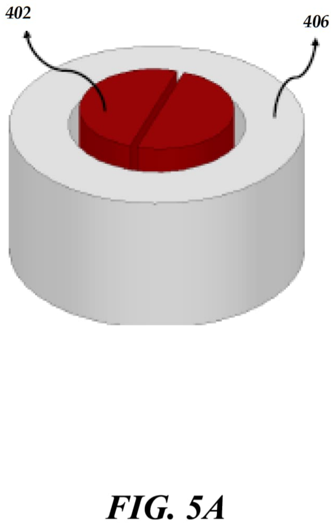

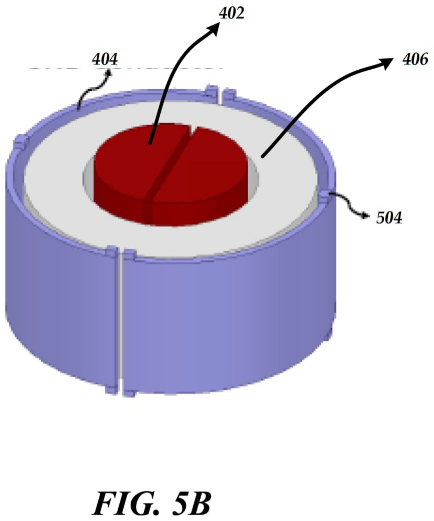

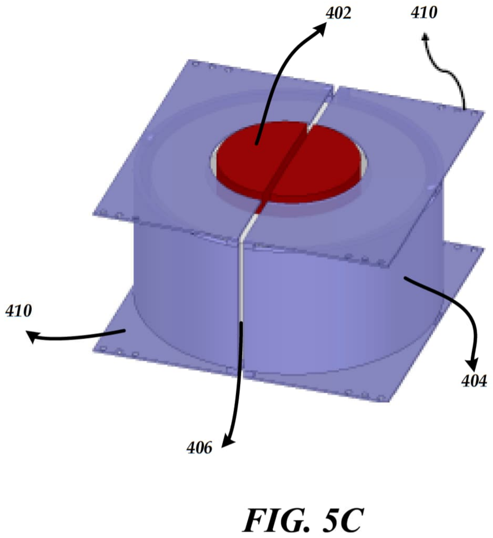

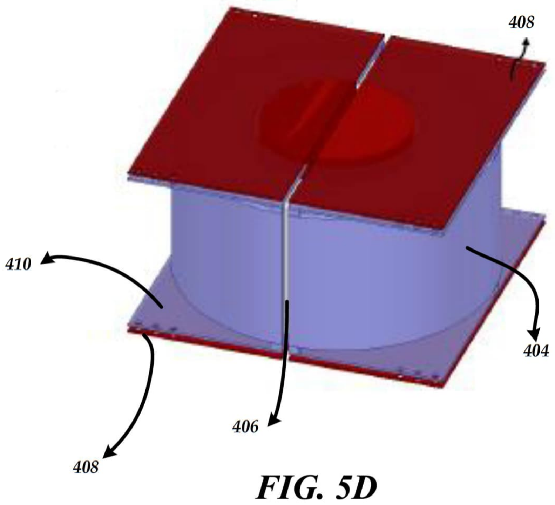

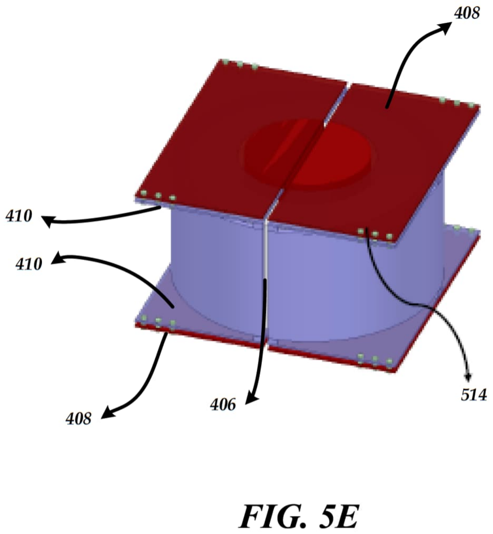

Figures 5A, 5B, 5C, 5D, and 5E illustrate an example process for assembling the example inductor cell 400 of Figure 4 in accordance with some embodiments of the present disclosure. The inductor cell 400 is shown at different stages of the example assembly process in Figures 5A, 5B, 5C, 5D, and 5E.

The process for assembling the inductor cell 400 can start with Figure 5A. As shown in Figure 5A, the power conductor 402 is positioned inside the powder core 406. As such, the powder core 406 surrounds the power conductor 402. The powder core 406 may provide desired magnetic properties for the inductor cell 400.

As shown in Figure 5B, the ground conductor 404 is further disposed around the powder core 406. As noted above, the ground conductor 404 can provide a return path for the electrical current associated with the inductor cell 400. Additionally, ground legs 504 are fabricated and included in the ground conductor 404. The ground legs 504 can facilitate soldering with other components (e.g., the ground plane 410) and provide mechanical support to the inductor cell 400.

As shown in Figure 5C, the ground plane 410 can be attached to and integrated into the inductor cell 400. More specifically, the ground plane 410 can be electrically connected to the ground conductor 404. As noted above, the ground plane 410 may be attached or fixed to the ground conductor 404 through the ground legs 504. The ground plane 410 may provide a low-impedance path for the return current and helping to reduce electromagnetic interference (EMI) and noise.

As shown in Figure 5D, the power plane 408 can be further attached to and integrated into the inductor cell 400. In some embodiments, the power plane 408 is electrically connected to the power conductor 402. As noted above, the power plane 408 may provide a low-impedance path for the supply current and helping to reduce voltage drops and power losses.

As shown in Figure 5E, a plurality of vias 514 can be added to the inductor cell 400. The plurality of vias 514 can provide vertical interconnections that connect the power planes 408 with each other, or connect the ground planes 410 with each other, thereby enabling efficient vertical power delivery from one of the PCBs 412 (e.g., a bottom plate) to the other of the PCBs 412 (e.g., a top plate). The plurality of vias 514 can facilitate the flow of current between the power conductor 402 and the ground conductor 404, thereby ensuring reliable electrical connections and maintaining the structural integrity of the inductor cell 400. In some embodiments, the two PCBs 412 can be further disposed respectively above and below the ground conductor 404, the powder core 406, and the power conductor 402 to obtain the inductor cell 400 shown in Figure 4.

### Example Dual-Phase Vertical Power Delivery

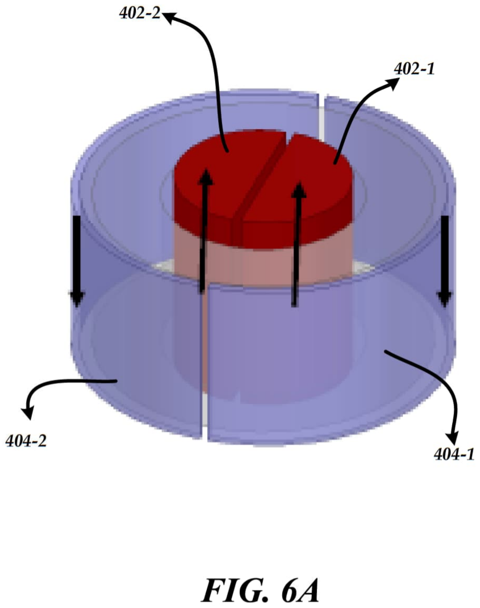

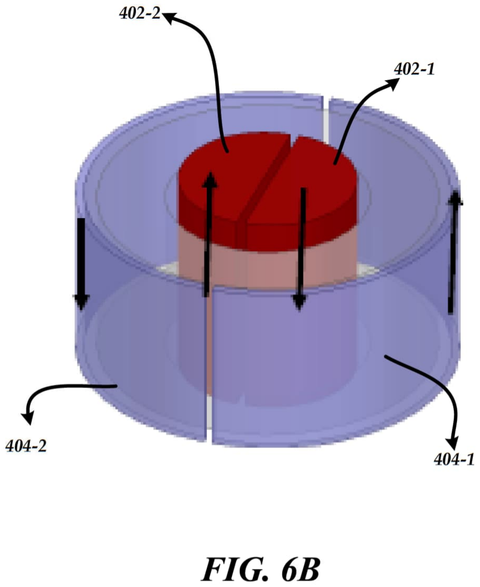

Figures 6A and 6B illustrate dual-phase vertical power delivery using the example inductor cell 400 of Figure 4 in accordance with some embodiments of the present disclosure. More specifically, Figures 6A and 6B illustrate a partial perspective view of the inductor cell 400 that is configured for dual-phase vertical power delivery. As noted above, under the dual-phase configuration, the inductor cell 400 may deliver power in two distinct phases (e.g., 0 degrees and 180 degrees). Under the dual-phase configuration, the power conductor 402 of the inductor cell may comprise two conductor pieces (e.g., a conductor piece 402-1 and a conductor piece 402-2). The ground conductor 404 of the inductor cell 400 may comprise two conductor pieces (e.g., a conductor piece 404-1 and a conductor piece 404-2). Compared with a single-phase configuration, the inductor cell 400 may achieve improved power delivery efficiency and better load regulation when configured to the dual-phase configuration.

Figure 6A illustrates the inductor cell 400 delivering power vertically in the 0 degree phase. As shown in Figure 6A, the currents delivered by the power conductor 402 (e.g., the conductor piece 402-1 and the conductor piece 402-2) are in phase (e.g., flow in the same direction at the same time). Also, currents returned by the ground conductor 404 (e.g., the conductor piece 404-1 and the conductor piece 404-2) are in phase.

Figure 6B illustrates the inductor cell 400 delivering power vertically in the 180 degree phase. As shown in Figure 6B, the currents delivered by the power conductor 402 (e.g., the conductor piece 402-1 and the conductor piece 402-2) are out of phase (e.g., flow in the opposite direction at the same time). Also, currents returned by the ground conductor 404 (e.g., the conductor piece 404-1 and the conductor piece 404-2) are out of phase.

### Inductor Arrays for Vertical Power Delivery

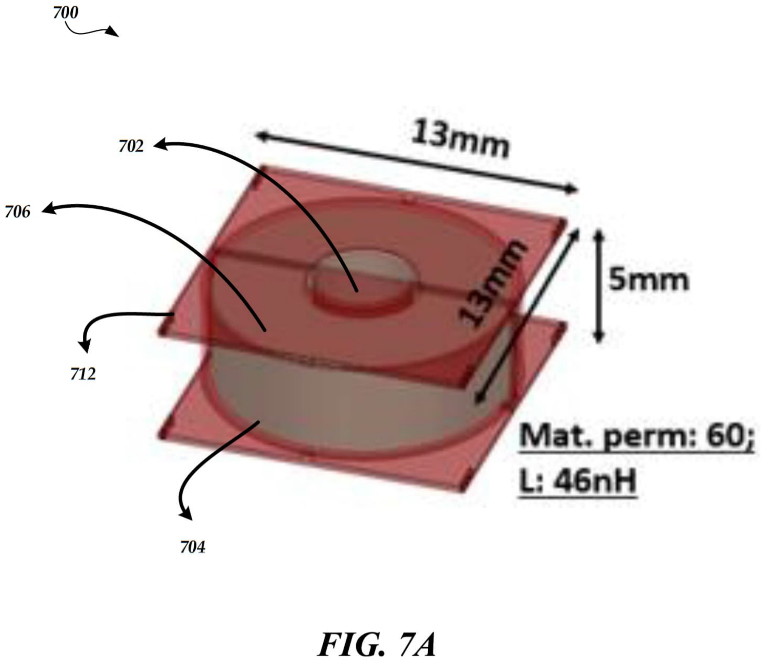

Figure 7A illustrates physical characteristics associated with an example inductor cell 700 for vertical power delivery in accordance with some embodiments of the present disclosure. The inductor cell 700 can be the same or similar to the example inductor cell 400 of Figure 4. As shown in Figure 7A, the inductor cell 700 includes a power conductor 702, a ground conductor 704, a powder core 706, and a PCB 712. The inductor cell 700 is one example implementation of an inductor cell for a particular vertical power delivery application. The PCB 712 may have a square shape, with each side measuring 13 millimeters (mm). The height of the inductor cell 700 is 5 mm.

As shown in Figure 7A, the material permeability (e.g., Mat. perm) of the powder core 706 used in the inductor cell 700 is 60. This value indicates the magnetic permeability of the core material, which affects the inductance and efficiency of the inductor cell 700. The inductance (L) of the inductor cell 700 is 46 nanohenries (nH). This value represents the ability of the inductor to store energy in its magnetic field.

As shown in Figure 7A, the power conductor 702, the ground conductor 704, and the powder core 706 are oriented in the vertical direction to facilitate vertical power delivery. The power conductor 702 and the powder core 706 are surrounded by the ground conductor 704.

Figure 7B illustrates an inductor array 750 formed by the example inductor cell of Figure 7A in accordance with some embodiments of the present disclosure. As shown in Figure 7B, the inductor array 750 includes multiple inductor cells 700 arranged in a grid pattern. The inductor array 750 can implement inductors of an array of power delivery modules. The inductor cells 700 of the inductor array can be included in voltage converters, such as buck converters.

As noted above, each inductor cell 700 in the inductor array 750 includes a power conductor, a ground conductor, and a powder core, all oriented in the vertical direction to facilitate vertical power delivery. The inductor cells are labeled with identifiers such as "Top1_1 Bot1_1," "Top1_2 Bot1_2," and so on, indicating their positions within the inductor array 750. The labels "Top" and "Bot" refer to the top and bottom plates of each inductor cell 700, respectively

As shown in Figure 7B, the inductor array 750 corresponds to a 3x3 grid or array, consisting of nine inductor cells 700. Each inductor cell 700 is positioned adjacent to its neighboring inductor cells 700, forming a compact and efficient layout for vertical power delivery. This arrangement allows for the integration of multiple inductor cells 700 into a single inductor array 750, which can be used in high-density computing applications requiring efficient power delivery. It should be noted that the inductor array 750 can be customized to include different numbers of inductor cells based on specific application requirements. The modular nature of the inductor array 750 allows for scalability and flexibility in design, making it suitable for various high-performance computing and advanced AI training systems.

### Example Block Diagram of Power Supply Module

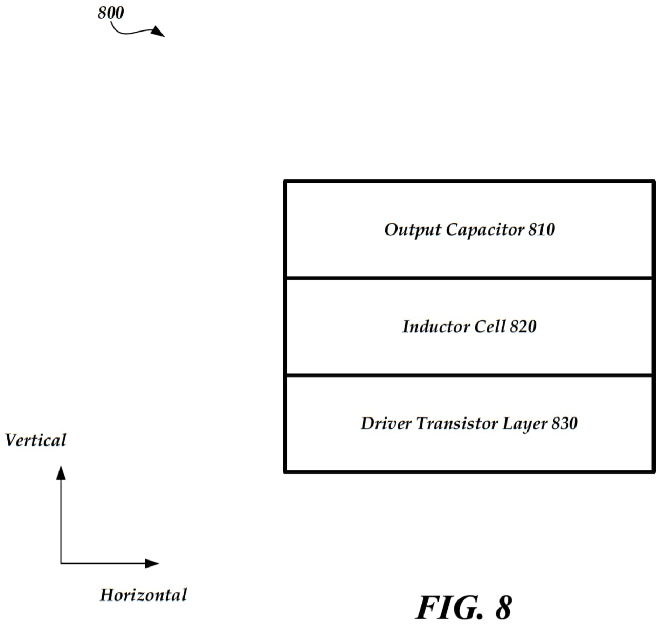

Figure 8 illustrates an example block diagram of components of a power supply module 800 for vertical power delivery in accordance with some embodiments of the present disclosure. The power supply module 800 can be the same or similar to the power supply module 102 of Figure 1, the power supply modules 102A-102I of Figure 2, and/or the power supply module 102A-102C of Figure 3. The power supply module 800 can also be referred to as a power delivery module. As shown in FIG. 8, the power supply module 800 includes an output capacitor 810, an inductor cell 820, and a driver transistor layer 830. The inductor cell 820 is sandwiched between the output capacitor 810 and the driver transistor layer 830 along a vertical direction.

In some embodiments, the inductor cell 820 can include one or more inductor cells (e.g., one or more inductor cells 400). As noted above, the inductor cell 820 can be stacked vertically between the output capacitor 810 and the driver transistor layer 830 to facilitate vertical power delivery along the vertical direction.

In some embodiments, the output capacitor 810 can include one or more capacitors that are positioned above the inductor cell 820 and the driver transistor layer 830. The output capacitor 810 can interface with a semiconductor chip (e.g., a semiconductor chip of the array of chips 104 shown in FIG. 1). The output capacitor 810 can smooth out voltage fluctuations such that the power supply module 800 can provide a stable output voltage (e.g., to the array of chips 104).

In some embodiments, the driver transistor layer 830 can include one or more metal oxide semiconductor field effect transistors. For example, the driver transistor layer 830 can include driver plus metal oxide semiconductor field effect transistors (DrMOS). In DrMOS, metal oxide semiconductor field effect transistors can be on-chip with power field effect transistors. The driver transistor layer 830 can control flow of current through the inductor cell 820 to regulate power delivered by the power supply module 800.

### Conclusion

The foregoing disclosure is not intended to limit the present disclosure to the precise forms or particular fields of use disclosed. As such, it is contemplated that various alternate embodiments and/or modifications to the present disclosure, whether explicitly described or implied herein, are possible in light of the disclosure. Having thus described embodiments of the present disclosure, a person of ordinary skill in the art will recognize that changes may be made in form and detail without departing from the scope of the present disclosure. Thus, the present disclosure is limited only by the claims.

It is to be understood that not necessarily all objects or advantages may be achieved in accordance with any particular example described herein. Thus, for example, those skilled in the art will recognize that some examples may be operated in a manner that achieves or optimizes one advantage or group of advantages as taught herein without necessarily achieving other objects or advantages as may be taught or suggested herein.

All of the processes described herein may be embodied in, and fully automated via, software code modules executed by a computing system that includes computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the example, some acts, events, or functions of any of the algorithms described herein can be performed in a different sequence, can be added, merged, or left out altogether (for example, not all described acts or events are necessary for the practice of the algorithms). Moreover, in some examples, acts or events can be performed concurrently, for example, through multi-threaded processing, interrupt processing, or multiple processors or processor cores, or on other parallel architectures, rather than sequentially. In addition, different tasks or processes can be performed by different machines and/or computing systems that can function together.

The various illustrative logical blocks and modules described in connection with the examples disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combination of the same, or the like. A processor can include electrical circuitry to process computer-executable instructions. In some examples, a processor includes an FPGA or other programmable device that performs logic operations without processing computer-executable instructions. A processor can also be implemented as a combination of computing devices, for example, a combination of a DSP and a microprocessor, a plurality of microprocessors, microprocessors in conjunction with a DSP core, or any other such configuration. Although described herein primarily with respect to digital technology, a processor may also include primarily analog components. A computing environment can include any type of computer system, including, but not limited to, a computer system based on a microprocessor, a mainframe computer, a digital signal processor, a portable computing device, a device controller, or a computational engine within an appliance, to name a few.

The elements of a method, process, routine, or algorithm described in connection with the embodiments disclosed herein can be embodied directly in hardware, in a software module executed by a processor device, or in a combination of the two. A software module can reside in RAM memory, flash memory, ROM memory, EPROM memory, EEPROM memory, registers, hard disk, a removable disk, a CD-ROM, or any other form of a non-transitory computer-readable storage medium. An exemplary storage medium can be coupled to the processor device such that the processor device can read information from, and write information to, the storage medium. In the alternative, the storage medium can be integral to the processor device. The processor device and the storage medium can reside in an ASIC. The ASIC can reside in a user terminal. In the alternative, the processor device and the storage medium can reside as discrete components in a user terminal.

The processes described herein or illustrated in the figures of the present disclosure may begin in response to an event, such as on a predetermined or dynamically determined schedule, on demand when initiated by a user or system administrator, or in response to some other event. When such processes are initiated, a set of executable program instructions stored on one or more non-transitory computer-readable media (e.g., hard drive, flash memory, removable media, etc.) may be loaded into memory (e.g., RAM) of a server or other computing device. The executable instructions may then be executed by a hardware-based computer processor of the computing device. In some embodiments, such processes or portions thereof may be implemented on multiple computing devices and/or multiple processors, serially or in parallel.

Conditional language such as, among others, "can," "could," "might" or "may," unless specifically stated otherwise, are otherwise understood within the context as used in general to convey that some examples include, while other examples do not include, some features, elements and/or steps. Thus, such conditional language is not generally intended to imply that features, elements and/or steps are in any way for examples or that examples necessarily include logic for deciding, with or without user input or prompting, whether these features, elements and/or steps are included or are to be performed in any particular example.

Disjunctive language such as the phrase "at least one of X, Y, or Z," unless specifically stated otherwise, is otherwise understood with the context as used in general to present that an item, term, etc., may be either X, Y, or Z, or any combination thereof (for example, X, Y, and/or Z). Thus, such disjunctive language is not generally intended to, and should not, imply that some examples require at least one of X, at least one of Y, or at least one of Z to each be present.

Any process descriptions, elements or blocks in the flow diagrams described herein and/or depicted in the attached figures should be understood as potentially representing modules, segments, or portions of code which include executable instructions for implementing specific logical functions or elements in the process. Alternate examples are included within the scope of the examples described herein in which elements or functions may be deleted, executed out of order from that shown, or discussed, including substantially concurrently or in reverse order, depending on the functionality involved as would be understood by those skilled in the art.

It should be emphasized that many variations and modifications may be made to the above-described examples, the elements of which are to be understood as being among other acceptable examples. All such modifications and variations are intended to be included herein within the scope of this disclosure.

Any process descriptions, elements or blocks in the flow diagrams described herein and/or depicted in the attached figures should be understood as potentially representing modules, segments, or portions of code which include executable instructions for implementing specific logical functions or elements in the process. Alternate implementations are included within the scope of the examples described herein in which elements or functions may be deleted, executed out of order from that shown, or discussed, including substantially concurrently or in reverse order, depending on the functionality involved as would be understood by those skilled in the art.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B, and C" can include a first processor configured to carry out recitation A working in conjunction with a second processor configured to carry out recitations B and C.

## Claims

1. An inductor cell, comprising:
a first plate;
a second plate;
a power conductor extending between the first plate and the second plate in a vertical direction;
an inductor core extending between the first plate and the second plate in the vertical direction; and
a ground conductor extending between the first plate and the second plate in the vertical direction,
wherein the power conductor is configured to deliver power between the first plate and the second plate along the vertical direction, and
wherein the inductor cell is configured as an inductor in a power delivery path.

2. The inductor cell of Claim 1, wherein the first plate comprises a power plane and a ground plane, wherein the power plane is electrically connected to the power conductor, and wherein the ground plane is electrically connected to the ground conductor.

3. The inductor cell of Claim 2, wherein the ground conductor comprises a plurality of soldering points for mounting the ground plane on the ground conductor.

4. The inductor cell of Claim 2 or 3, further comprising a plurality of vias configured to electrically connect the power plane with another power plane, and/ or further comprising a plurality of vias configured to electrically connect the ground plane with another ground plane.

5. The inductor cell of one of the preceding claims, wherein the first plate comprises a first printed circuit board (PCB), and wherein the second plate comprises a second PCB.

6. The inductor cell of one of the preceding claims, wherein the inductor core at least partially surrounds the power conductor, and wherein the ground conductor at least partially surrounds the inductor core, and/or wherein the inductor core is contiguous, and wherein the power conductor includes two power conductor pieces and the ground conductor includes two ground conductor pieces to deliver the power under a dual-phase operation, or wherein the inductor core is contiguous, and wherein the power conductor includes multiple power conductor pieces and the ground conductor includes multiple ground conductor pieces to deliver the power under a multi-phase operation.

7. An inductor array, comprising:
a plurality of inductor cells arranged in an array, wherein each of the plurality of inductor cells comprises:
a power conductor;
an inductor core;
a ground conductor;
a first plate; and
a second plate,
wherein the power conductor, the inductor core, and the ground conductor are disposed between the first plate and the second plate, and
wherein electrical power is delivered between the first plate and the second plate along a vertical direction through the power conductor.

8. The inductor array of Claim 7, wherein the power conductor is contiguous and the ground conductor is contiguous, and each of the plurality of inductor cells is configured to deliver the electrical power under a single-phase operation.

9. The inductor array of Claim 7 or 8, wherein the power conductor includes four power conductor pieces and the ground conductor includes four ground conductor pieces to deliver the electrical power under a quad-phase operation, or wherein the power conductor includes two power conductor pieces and the ground conductor includes two ground conductor pieces to deliver the electrical power under a dual-phase operation.

10. The inductor array of one of Claims 7 to 9, wherein the inductor core at least partially surrounds the power conductor, and wherein the ground conductor at least partially surrounds the inductor core, and/or wherein the power conductor is substantially cylindrical.

11. The inductor array of one of Claims 7 to 10, wherein the ground conductor comprises one or more ground legs configured to facilitate soldering between the ground conductor and the first plate.

12. A computing system, comprising:
an array of chips comprising a plurality of chips; and
an array of power delivery modules comprising a plurality of power delivery modules,
wherein each power delivery module of the plurality of power delivery modules is positioned vertically relative to and configured to vertically supply power to a respective chip of the plurality of chips, and
wherein each power delivery module of the plurality of power delivery modules comprises an inductor cell, and the inductor cell comprises:
a power conductor;
a ground conductor around the power conductor;
a first printed circuit board;
a second printed circuit board,
wherein the power conductor and the ground conductor are positioned between the first printed circuit board and the second printed circuit board, and are arranged to deliver power between the first printed circuit board and the second printed circuit board.

13. The computing system of Claim 12, wherein a system on a wafer includes the array of chips.

14. The computing system of Claim 12 or 13, wherein each power delivery module of the plurality of power delivery modules comprises a buck converter, and the inductor cell is an output inductor of the buck converter, and/or wherein each power delivery module of the plurality of power delivery modules comprises:
a capacitor; and
a driver plus metal oxide semiconductor field effect transistor layer,
wherein the inductor cell is positioned vertically between the capacitor and the driver plus metal oxide semiconductor field effect transistor layer.

15. An inductor array, comprising:
a plurality of inductor cells arranged in an array, wherein each of the plurality of inductor cells comprises the features of one of claims 1 to 6.
